(19) Europäisches Patentamt
European Patent Office
Office européen des brevets

(11) **EP 2 515 433 B1**

(12) **FASCICULE DE BREVET EUROPEEN**

(45) Date de publication et mention
de la délivrance du brevet:
**06.09.2017 Bulletin 2017/36**

(51) Int Cl.:
***H03D 3/26*** *(2006.01)*  ***H03B 15/00*** *(2006.01)*

(21) Numéro de dépôt: **12163833.2**

(22) Date de dépôt: **12.04.2012**

(54) **Démodulateur d'un signal électrique modulé en fréquence**

Demodulator eines elektrischen frequenzmodulierten Signals

Demodulator of a frequency-modulated electric signal

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.04.2011 FR 1153421**

(43) Date de publication de la demande:
**24.10.2012 Bulletin 2012/43**

(73) Titulaire: **Commissariat à l'Énergie Atomique
et aux Énergies Alternatives
75015 Paris (FR)**

(72) Inventeurs:
• **Quinsat, Michael
38000 Grenoble (FR)**
• **Cyrille, Marie- Claire
38650 Sinard (FR)**
• **Ebels, Ursula
38100 Grenoble (FR)**
• **Michel, Jean-Philippe
38600 Fontaine (FR)**

(74) Mandataire: **Colombo, Michel et al
Brevinnov
310 avenue Berthelot
69008 Lyon (FR)**

(56) Documents cités:
**US-A1- 2010 097 730    US-A1- 2010 296 203
US-A1- 2011 051 481**

• **YAMAGUCHI A ET AL: "Self-homodyne rf
demodulator using a ferromagnetic nanowire",
APPLIED PHYSICS LETTERS, AIP, AMERICAN
INSTITUTE OF PHYSICS, MELVILLE, NY, US, vol.
90, no. 21, 22 mai 2007 (2007-05-22), pages
212505-212505, XP012094959, ISSN: 0003-6951,
DOI: 10.1063/1.2742588**

EP 2 515 433 B1

**Description**

L'invention concerne un démodulateur d'un signal électrique modulé en fréquence autour d'une fréquence porteuse $f_p$ avec une fréquence de modulation $f_m$. L'invention a également pour objet un procédé de démodulation d'un tel signal électrique modulé en fréquence.

Dans les signaux électriques modulés en fréquence, une information est codée par une fréquence. Par exemple, de tels signaux sont émis ou reçus par un téléphone portable ou une chaîne radio.

Il existe donc un très grand nombre de démodulateurs utilisés de nos jours pour démoduler ces signaux. Par exemple, les différents types de démodulateurs suivants sont connus :

- des démodulateurs à quadrature de phase,
- des démodulateurs synchrones,
- ... etc.

Tous ces démodulateurs connus comportent :

- une borne d'acquisition sur laquelle est reçu le signal modulé en fréquence, et
- une borne de restitution sur laquelle est restitué le signal électrique démodulé en fréquence.

Toutefois, tous ces démodulateurs connus ont en commun d'être encombrants et, souvent, complexes.

De l'état de la technique est également connu de :

- US2011/051481A1,
- US2010/296203A1,
- US2010/097730A1,
- Yamaguchi et al : « Self-homodyne rf demodulator using ferromagnetic nanowire », Applied Physics Letters, AIP, American Institute of Physics, Melville, NY, US, Vol. 90, n°21, 22/5/2007, pages 212505-212505.

L'invention vise à remédier à cet inconvénient en proposant un démodulateur moins encombrant.

Elle a donc pour objet un démodulateur conforme à la revendication 1

Le démodulateur ci-dessus utilise principalement un dispositif magnétorésistif dont l'électrode de sortie est raccordée à un filtre passe-bas. Les dispositifs magnétorésistifs sont particulièrement peu encombrants pour transformer un signal modulé en fréquence en un signal modulé en amplitude. En effet, ils présentent généralement une section transversale inférieure à 10 $\mu$m$^2$ et une épaisseur de quelques micromètres (inférieure à 10 $\mu$m). Ainsi, grâce à l'utilisation du dispositif magnétorésistif dans le démodulateur ci-dessus, l'encombrement du démodulateur est réduit.

Les modes de réalisation de ce démodulateur peuvent comporter une ou plusieurs des caractéristiques des revendications dépendantes.

Ces modes de réalisation du démodulateur présentent en outre l'avantage suivant :

- utiliser un oscillateur radiofréquence synchronisable sur les fréquences $\alpha f_1$ et $\alpha f_2$ où $\alpha$ est strictement supérieur à un, accroît la sensibilité du démodulateur.

L'invention a également pour objet un procédé de démodulation conforme à la revendication 4.

Les modes de réalisation de ce procédé peuvent comporter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :

- la figure 1 est une illustration schématique d'un démodulateur d'un signal électrique modulé en fréquence ;
- la figure 2 est un chronogramme partiel d'un signal modulé en fréquence ;
- la figure 3 est une illustration schématique d'un oscillateur radiofréquence utilisé dans le démodulateur de la figure 1 ;
- la figure 4 est un organigramme d'un procédé de démodulation à l'aide du démodulateur de la figure 1 ;
- les figures 5 à 7 sont des chronogrammes illustrant différents aspects des signaux électriques modulés et démodulés ;
- la figure 8 est un autre mode de réalisation d'un oscillateur radiofréquence utilisable dans le démodulateur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

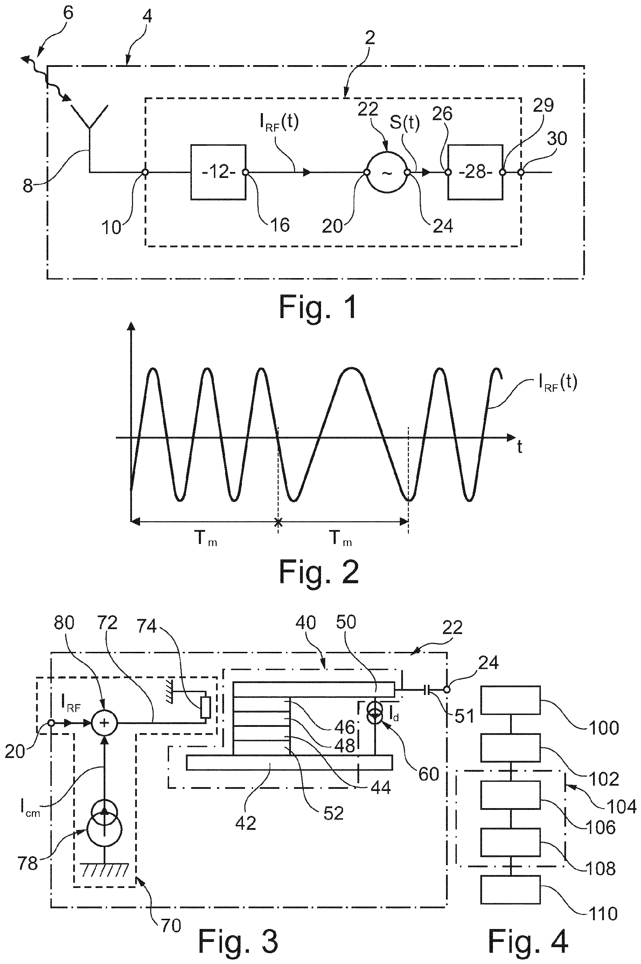

La figure 1 représente un démodulateur 2 d'un signal électrique modulé en fréquence. Ici, le démodulateur 2 est décrit dans le cas particulier où il fait partie d'un appareil 4 propre à recevoir par l'intermédiaire d'une liaison sans fil 6 le signal modulé en fréquence. Par exemple, l'appareil 4 est un téléphone portable et la liaison 6 est une liaison radio.

L'appareil 4 est équipé d'une antenne 8 pour établir la liaison sans fil 6. L'antenne 8 convertit le signal radio en un signal électrique qui est transmis à une borne 10 d'acquisition du signal électrique du démodulateur 2. Entre l'antenne 8 et la borne 10, l'appareil 4 peut comporter différents blocs électroniques qui n'ont pas été représentés pour simplifier la figure 1.

Dans le signal radio reçu par l'antenne 8, les informations sont codées en modulant en fréquence une porteuse par les informations à recevoir. Ici, la modulation utilisée est connue sous l'acronyme anglais FSK (Frequency Shift Keying).

Le démodulateur 2 comprend un bloc 12 de mise en forme du signal électrique modulé en fréquence. Ce bloc 12 permet de régler l'amplitude du signal modulé en fréquence. A cet effet, il comporte notamment un amplificateur. Ici, le bloc 12 permet également d'améliorer le rapport signal/bruit du signal reçu.

Le signal mis en forme généré par le bloc 12 est restitué sur une sortie 16. Ce signal est un courant électrique noté $I_{RF}(t)$. Ce signal $I_{RF}(t)$ est représenté en fonction du temps t sur le chronogramme de la figure 2.

Ce signal $I_{RF}(t)$ utilise seulement deux fréquences $f_1$ et $f_2$ pour coder les informations à transmettre. Ici, par convention, on considère que les fréquences $f_1$ et $f_2$ sont utilisées pour coder des bits d'informations ou états égaux, respectivement, à « 0 » et à « 1 ».

Les fréquences $f_1$ et $f_2$ sont centrées autour d'une fréquence porteuse $f_p$. Par exemple, la fréquence $f_p$ est définie par la relation suivante : $f_p = (f_1 + f_2)/2$.

Typiquement, la fréquence $f_p$ est un signal radiofréquence, c'est-à-dire un signal dont la fréquence est comprise entre 100 MHz et 60 ou 120 GHz et, de préférence, comprise entre 700 MHz et 40 GHz.

La profondeur de modulation du signal $I_{RF}(t)$ est supérieure à 100 kHz et, de préférence, supérieure à 100 MHz. La profondeur de modulation est la différence entre les fréquences $f_1$ et $f_2$. Par exemple, ici, la profondeur de modulation est de 200 MHz.

Sur la figure 2, la durée de modulation pour transmettre un bit d'information est notée $T_m$. Cette durée $T_m$ correspond à une fréquence de modulation $f_m$ donnée par la relation suivante : $f_m = 1/T_m$. La fréquence $f_m$ est généralement inférieure à deux fois la fréquence $f_p$ de la porteuse. Ici, la fréquence $f_m$ est inférieure ou égale à 10 MHz et supérieure ou égale à 2 MHz.

La sortie 16 est directement raccordée sur une borne 20 de synchronisation d'un oscillateur radiofréquence 22. Cet oscillateur 22 produit un signal oscillant s(t) sur une électrode 24 de sortie. L'électrode 24 est directement raccordée à l'entrée 26 d'un filtre passe-bas 28. Une sortie 29 de ce filtre passe-bas est directement raccordée à une borne 30 de restitution sur laquelle le démodulateur 2 restitue le signal électrique démodulé en fréquence. L'électrode 24 est donc ici raccordée à la borne 60 uniquement par l'intermédiaire du filtre 28.

La fréquence de coupure $f_c$ du filtre 28 à -3 dB est strictement inférieure à la fréquence $f_p$ de la porteuse. La fréquence $f_c$ est également supérieure ou égale à la fréquence $f_m$ de modulation. De préférence, la fréquence $f_c$ est supérieure ou égale à la fréquence $f_m$ et strictement inférieure à deux fois la fréquence $f_p$.

Sur la figure 2, deux périodes $T_m$ ont été représentées. Sur la première période $T_m$, la porteuse est modulée avec la fréquence $f_1$ tandis que sur la deuxième période, la porteuse est modulée avec la fréquence $f_2$.

Avantageusement, quel que soit le bit d'information codé, l'amplitude du signal $I_{RF}(t)$ est sensiblement constante. Par sensiblement constante, on désigne le fait que les amplitudes des oscillations pendant deux périodes $T_m$ successives quelconques sont égales à $\pm 5\%$ près et, de préférence, à $\pm 1\%$ près.

Le facteur de qualité des oscillations sur chaque période $T_m$ est bon. Par facteur de qualité, on désigne ici le rapport suivant :

$$Q = f_t/\Delta f$$

où :

- Q est le facteur de qualité,
- $f_t$ est la fréquence des oscillations, et
- $\Delta f$ est la largeur à mi-hauteur de la raie centrée sur la fréquence $f_t$ dans le spectre de puissance de ces oscillations.

Un facteur de qualité est considéré comme bon si celui est supérieur à 1000 voire 10000.

La figure 3 représente plus en détail un exemple de réalisation de l'oscillateur 22. Cet oscillateur 22 est issu de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F., Etienne, P., Creuzet, G., Friederch, A. and Chazelas, J., " Giant magnetoresistance of (001)Fel(001)Cr magnetic superlattices ", Phys.Rev.Lett., 61 (1988) 2472), ou la magnétorésistance tunnel (Moodera, JS., Kinder, LR., Wong, TM. and Meservey,R.. "Large magnetoresistance at room temperature in ferromagnetic thin film tunnel junctions", Phys.Rev.Lett 74 , (1995) 3273-6).

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversal and Spin-Wave Excitations in Co /Cu /Co Pillars ", Phys.Rev.Lett. 84, 3149 (2000)).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques. Les demandes de brevet US 5 695 864 et EP1 860 769 décrivent divers développements mettant en oeuvre le principe physique mentionné précédemment. Ils décrivent notamment la précession de l'aimantation d'une couche magnétique traversée par un courant électrique polarisé en spin. Les principes physiques mis en oeuvre ainsi que la terminologie utilisée sont également décrits et définis dans la demande de brevet FR2 892 871.

La fréquence d'oscillation de ces oscillateurs radiofréquences est ajustée en jouant sur l'intensité du courant qui les traverse et, éventuellement en plus, sur un champ magnétique externe.

Ces oscillateurs radiofréquences étant connus, seul les éléments nécessaires à la compréhension du fonctionnement du démodulateur 2 sont décrits plus en détail.

L'oscillateur 22 comprend un dispositif magnétorésistif 40. Ce dispositif 40 est formé d'un empilement de couches magnétiques et non magnétiques. Cet empilement peut former :

- une jonction tunnel également connue sous l'acronyme anglais de TMR (Tunnel Magnetoresistance), ou
- une vanne de spin également connue sous l'acronyme anglais de GMR (Giant Magnetoresistance).

Ici, le dispositif 40 est décrit dans le cas particulier où l'empilement forme une jonction tunnel. A cet effet, l'empilement comporte au moins les couches suivantes :

- une électrode d'entrée 42 sur laquelle est injecté un courant électrique continu $I_d$,
- une couche magnétique 44, dite « couche de référence », apte à polariser en spin le courant électrique injecté sur l'électrode 42 et dont l'aimantation est de direction fixe,
- une couche magnétique 46, dite « couche libre », dont l'aimantation peut osciller lorsqu'elle est traversée par le courant polarisé en spin,
- une couche 48 non magnétique, dite « espaceur » ou « spacer » en anglais, interposée entre les deux couches précédentes pour créer la jonction tunnel, et
- une électrode de sortie 50 sur laquelle est produit le signal oscillant s(t).

Pour obtenir une densité de courant élevée, la section transversale d'au moins l'une des couches de l'empilement présente typiquement un diamètre inférieure à 300nm et, de préférence, inférieure à 200 ou 100nm. Lorsque la section transversale n'est pas un disque, le terme « diamètre » doit être compris comme signifiant « diamètre hydraulique ». Typiquement, par densité de courant « élevée » on désigne une densité de courant supérieure à $10^6 A/cm^2$ ou $10^7 A/cm^2$.

Ce dispositif magnétorésistif 40 est conformé selon une géométrie connue sous l'acronyme CPP (« current perpendicular to plane »). Plus précisément, sur la figure 2, le dispositif magnétorésistif adopte une structure connue sous le terme de « nanopilier ». Dans cette structure les couches entres les électrodes 42 et 50 ont la même section horizontale.

La largeur L des différentes couches qui composent le pilier est constante. Ici, la largeur L est, typiquement, comprise entre 20 nm et 200 nm.

Les électrodes 42 et 50 permettent d'amener le courant qui traverse les différentes couches formant le dispositif magnétorésistif perpendiculairement au plan de ces couches. L'électrode 50 est raccordée à l'électrode 24 par l'intermédiaire d'un condensateur 51.

Les couches 44, 46 et 48 sont agencées et conformées de manière à permettre l'apparition des propriétés magnétoresistives, c'est-à-dire une variation de la résistance du pilier en fonction des directions d'aimantation des couches 44 et 46.

Pour améliorer la lisibilité de la figure 1, les proportions entre l'épaisseur des différentes couches n'a pas été préservée.

La couche de référence 44 est réalisée dans un matériau magnétique électriquement conducteur. Sa face supérieure est directement en contact avec l'espaceur 48. Elle présente une direction de plus facile aimantation comprise dans le plan de la couche.

La couche de référence 44 a pour fonction de polariser en spin les électrons du courant qui la traverse. Elle présente donc une épaisseur suffisante pour réaliser cette fonction.

Par exemple, la couche de référence 44 est réalisée en cobalt (Co), Nickel (Ni), Fer(Fe) ou leur alliage (CoFe, NiFe, CoFeB ...etc.). L'épaisseur de la couche de référence 44 est de l'ordre de quelques nanomètres. La couche de référence 44 peut être laminée par insertion de quelques (typiquement de 2 à 4) très fines couches de cuivre, d'argent ou d'or d'épaisseur de l'ordre de 0,2 à 0,5 nm pour réduire la longueur de diffusion de spin.

Ici, la couche de référence 44 présente une aimantation dont la direction est fixe. Par aimantation de direction fixe, on désigne le fait que la direction du moment magnétique de la couche de référence 44 est plus difficile à modifier que la direction du moment magnétique de la couche libre 46. Pour obtenir cela, ici, l'aimantation de la couche de référence 44 est piégée par une couche antiferromagnétique conductrice 52 interposée entre la couche de référence 44 et l'électrode 42. La face supérieure de la couche 52 est directement en contact avec la face inférieure de la couche de référence 44.

Typiquement, l'épaisseur de la couche 52 est comprise entre 5 et 50 nm. Elle peut être réalisée dans un alliage de manganèse tel que l'un des alliages suivants IrMn, PtMn, FeMn, ... etc. Par exemple, cette couche 52 est réalisée dans un matériau choisi dans le groupe comprenant IrMn, FeMn, PtMn, NiMn.

L'espaceur 48 est une couche non magnétique. Cet espaceur 48 est suffisamment fin pour permettre au courant polarisé en spin de passer de la couche de référence 44 à la couche libre 46 en limitant la perte de polarisation. A l'inverse, l'épaisseur de cet espaceur 48 est suffisamment grande pour assurer le découplage magnétique entre les couches 44 et 46.

L'espaceur 48 est réalisé dans un matériau isolant tel qu'un oxyde ou un nitrure d'aluminium, un oxyde de magnésium, du nitrure de tantale, du titanate de strontium ($SrTiO_3$), ... etc. Le pilier présente alors des propriétés magnétorésistives tunnel ou TMR (Tunnel Magnetoresistance) et l'espaceur 48 forme une barrière tunnel. Dans ce cas, l'épaisseur de l'espaceur 48 est typiquement comprise entre 0,5 nm et 3 nm.

Ici, la barrière tunnel du dispositif 40 est fine pour présenter un facteur RA faible, c'est-à-dire compris entre 0.1 et 20 $\Omega\mu m^2$, et avantageusement inferieur à 10 voire à 5 $\Omega\mu m^2$. Le facteur RA d'une barrière tunnel est le produit de la résistance de la barrière tunnel avec son aire. Ici, l'aire est la superficie de la section transversale de la barrière tunnel.

Généralement, plus le facteur RA de la barrière tunnel est élevé plus la plage de variation de la résistivité de la jonction tunnel est élevé (par exemple supérieur à 10 %) et meilleure est la sensibilité de la jonction tunnel à la précession de l'aimantation dans la couche libre. Typiquement, pour des facteurs RA de cet ordre, on peut générer facilement des oscillations et il est possible d'obtenir des TMR comprise entre 20% et 150% du facteur RA (typiquement 80% du facteur RA pour un facteur RA de 1 $\Omega\mu m^2$), ce qui permet d'obtenir une bonne sensibilité de la jonction tunnel à la précession de l'aimantation dans la couche libre.

La couche libre 46 est une couche magnétique électriquement conductrice dont l'aimantation peut plus facilement tourner ou « précesser » que celle de la couche de référence 44.

De nombreux modes de réalisation de la couche libre sont possibles. Par exemple, des modes de réalisation possibles de cette couche libre sont décrits dans la demande de brevet déposée sous le numéro FR 0 957 888 et dans la demande de brevet publiée sous le numéro FR2 892 871.

La face inférieure de la couche 46 est directement en contact avec la face supérieure de l'espaceur 48. La face supérieure est quant à elle directement en contact avec l'électrode 50. Cette couche 46 est par exemple réalisée dans un matériau ferromagnétique tel que du cobalt, du nickel ou du fer ou dans un alliage de ces différents métaux (par exemple CoFe, CoFeB, NiFe, ... etc.).

En absence de courant polarisé en spin et de champ magnétique extérieur, la direction M du moment magnétique global de la couche 46 est orientée parallèlement au plan de cette couche. La direction M correspond alors à la direction de plus facile aimantation de la couche libre.

Typiquement, cet empilement de couches est réalisé sur la face supérieure d'un substrat non représenté ici.

De préférence, le dispositif magnétorésistif 40 est fortement non linéaire. Par « fortement non linéaire » on désigne le fait que la dérivée, notée $df_{lo}/dA$, de la fréquence libre $f_{lo}$ du dispositif 40 en fonction de l'amplitude A des variations de la résistance du dispositif 40 est supérieure à 10 MHz/$\Omega$ sur la plage de fonctionnement de l'oscillateur 22.

Le dispositif 40 fonctionne comme un oscillateur à transfert de spin également connue sous l'acronyme anglais STO (Spin Transfer Oscillator) lorsque l'intensité du courant continu $I_d$ polarisé en spin dépasse un seuil $I_c$ connu sous le terme de « courant critique d'oscillation». Lorsque l'intensité du courant $I_d$ dépasse ce seuil $I_c$, l'aimantation de la couche libre du dispositif 40 précesse de façon entretenue. Le signal s(t) oscille alors à la fréquence libre $f_{lo}$. Typiquement, le seuil $I_c$ correspond à une densité de courant supérieure à $10^7 A/cm^2$ dans la section transversale des couches de l'empilement. Dans le cas contraire, le dispositif 40 se comporte comme un résonateur, également désigné par l'acronyme STR (Spin Transfer Resonator), et le signal oscillant généré est amorti et non pas entretenu. Toutefois, même dans ce cas, pour générer le signal oscillant amorti, la densité de courant dans la section transversale des couches de l'empilement doit être élevée.

Pour générer le courant continu $I_d$, l'oscillateur 22 comporte une source 60 de courant continu. Dans ce mode de réalisation, la source 60 génère un courant continu $I_d$ dont l'intensité est supérieure au seuil $I_c$. Par exemple, la source 60 est raccordée entre les électrodes 42 et 50.

Pour régler la fréquence libre $f_{lo}$ d'oscillation du signal s(t) généré par le dispositif 40, ici, l'oscillateur 22 est également équipé d'un générateur 70 d'un champ magnétique continu ou constant $H_b$. Ce générateur 70 est agencé par rapport au dispositif 40 de manière à ce que les lignes du champ magnétique $H_b$ traversent la couche libre 46. Par exemple, ce générateur 70 se présente sous la forme d'une piste conductrice 72 alimentée en courant continu $I_{cm}$ par une source de courant 78. La piste 72 est placée à proximité de l'empilement des couches du dispositif 40. Par exemple, cette piste 72 est agencée par rapport à la couche 46 de manière à ce que les lignes de champ magnétique générées soient parallèles à la direction M de plus facile aimantation de la couche 46. De préférence, pour limiter la consommation électrique du générateur 70, la distance la plus courte qui sépare cette piste conductrice 72 de la couche libre 46 est inférieure à 100 $\mu$m et, avantageusement, inférieure à 10$\mu$m voire à 1 $\mu$m. Sur la figure 3, la résistivité de cette piste 72 est représentée par une résistance 74. Par exemple, la valeur de résistance 74 est égale à 10 $\Omega$ et correspond à la résistance de la piste conductrice 72 entre la sortie de la source 78 et un potentiel de référence tel que la masse.

Ce générateur 70 comporte un sommateur 80 dont une entrée est directement raccordée à la borne 20 de synchronisation et l'autre entrée est directement raccordée à la sortie de la source 78 du courant continu $I_{cm}$. La sortie de ce sommateur 80 est directement raccordée à la piste 72. Ceci permet de générer, en plus du champ magnétique $H_b$, un champ magnétique alternatif $H_a$ dont la fréquence est égale à celle du signal $I_{RF}(t)$.

La fréquence d'oscillation de l'oscillateur 22 est notée $f_o$. En absence de signal sur la borne 20, cette fréquence $f_o$ est égale à la fréquence libre $f_{lo}$ d'oscillation de l'oscillateur 22. La fréquence libre est fonction du champ $H_b$ et de l'intensité du courant $I_d$. Lorsqu'un signal oscillant est reçu sur la borne 20, l'oscillateur 22 peut se synchroniser sur ce signal oscillant. Lorsque l'oscillateur 22 est synchronisé, celui-ci produit un signal oscillant s(t) qui oscille en phase avec le signal reçu sur la borne 20. De plus, lorsqu'il est synchronisé, la fréquence $f_0$ du signal s(t) produit sur l'électrode 50 devient égale à $\alpha f_t$, où :

- $f_t$ est la fréquence du signal reçu sur la borne 20, et
- $\alpha$ est un nombre rationnel s'écrivant sous la forme d'une fraction M/P, où M et P sont des entiers positifs non nuls.

M peut être un entier naturel plus grand que P ou plus petit. M et P peuvent aussi être égaux. P peut être égal à un.

A ce stade, on notera que toutes les valeurs de $\alpha$ ne sont pas possibles. En réalité, seules certaines valeurs particulières de $\alpha$ sont possibles. A ce sujet, on pourra se référer à l'article suivant :

Sergei Urazhdin et Phillip Tabor, « Franctional synchronization of spin-torque nano-oscillators », Physical review letters, PRL 105, 104101, 3 septembre 2010.

Les valeurs de $\alpha$ possibles sont par exemple déterminées expérimentalement en faisant varier la fréquence libre $f_{lo}$ et en injectant sur la borne 20 un signal de fréquence constamment égale à la fréquence $f_t$. Pour modifier la fréquence libre $f_{lo}$, il est possible de modifier l'intensité du champ magnétique $H_b$ et/ou l'intensité du courant $I_d$. Cela revient donc ici à modifier l'intensité du courant $I_d$ et/ou l'intensité du courant $I_{cm}$. En effet, il est connu que la fréquence libre $f_{lo}$ dépend de l'intensité du champ magnétique $H_b$ qui traverse la couche libre et de l'intensité du courant continu $I_d$. Par exemple, il est possible d'estimer la fréquence libre $f_{lo}$ à l'aide de la relation suivante :

$$\omega(H_b, I_d) = \omega_o(H_b) + Np(I_d) \qquad (1),$$

où :

- $\omega(H_b, I_d)$ est la pulsation de la fréquence libre $f_{lo}$, c'est-à-dire $2\pi f_{lo}$.
- $\omega_o(H_b)$ est la pulsation de l'oscillateur 22 causée par le champ magnétique $H_b$,
- N est une constante déterminable expérimentalement, et
- $p(I_d)$ est l'amplitude des oscillations du signal s(t) en fonction de l'intensité du courant $I_d$.

La pulsation $\omega_0(H_b)$ peut être donnée par une loi de Kittel. Par exemple, lorsque le champ magnétique $H_b$ généré par le générateur 70 est parallèle à l'axe de plus facile aimantation de la couche libre 46, alors la pulsation $\omega_o(H_b)$ est donnée par la relation suivante :

$$\omega_o(H_b)= (\gamma_o/2\pi)(H_b(H_b + 4\pi M_s))^{1/2} \ (2),$$

où :

- $\gamma_o$ est environ égal à 2,82 MHz/Oe,
- $\pi$ est le symbol "pi" radians, et
- $4\pi M_s$ est la magnétisation à saturation (environ 16.000 Oe pour une couche en CoFeB).

L'unité « Oe » est un Oersted (= $10^3/(4\pi)$ A/m soit environ 80 A/m).

Par exemple en faisant varier l'intensité du champ $H_b$ de 1 Oe à 5 kOe, cela fait varier la fréquence libre $f_{lo}$ de 356 MHz à 29 GHz. De préférence, on fait ici varier le champ $H_b$ de 50 Oe à 1,2 kOe, ce qui correspond à une variation de la fréquence libre $f_{lo}$ de 2 GHz à 13 GHz. Dans le cas du générateur 70, l'intensité du champ magnétique $H_b$ est modifiée en faisant varier l'intensité du courant $I_{cm}$.

Dans la relation (1), N est une constante en Hertz qui est propre au dispositif magnétorésistif 40. Elle est déterminable expérimentalement. Par exemple, l'évolution de la fréquence libre $f_{lo}$ en fonction de l'intensité du courant $I_d$ pour des oscillations de l'aimantation de la couche libre dans son plan, est mesurée. A partir de ces mesures, la constante N peut être calculée. Typiquement, celle-ci est de l'ordre de quelques GHz. Par exemple, ici $N/2\pi = 7,5$ GHz.

Si les oscillations de l'aimantation de la couche libre ne sont pas comprises dans son plan, la constante $N/2\pi$ est typiquement supérieure à 20 GHz.

Plus d'explications sur les relations reliant la fréquence libre $f_{lo}$ aux différents paramètres du dispositif magnétorésistif peuvent être trouvées dans l'article suivant :

A. Slavin et V. Tiberkevich, « Nonlinear auto-oscillator theory of microwave generation by spin-polarized current » IEEE Transaction on magnetics, vol n°45, pp. 1875-1918(2009).

Lorsque l'oscillateur 22 est synchronisé sur la fréquence $f_t$ alors le facteur de qualité de l'oscillateur 22 est meilleur qu'en absence de synchronisation. Typiquement, le facteur de qualité de l'oscillateur 22 est cent fois ou mille fois voire $10^6$ fois supérieur, lorsqu'il est synchronisé, à son facteur de qualité lorsqu'aucun signal n'est reçu par l'intermédiaire de la borne 20.

De plus, lorsque l'oscillateur 22 est synchronisé, le bruit basse fréquence c'est-à-dire la puissance des oscillations de fréquences inférieures à 1 GHz et, de préférence, inférieure à 100 Hz est très petite. Par très petite, on indique ici le fait que la puissance du bruit basse fréquence est au moins dix fois inférieure à la puissance du bruit basse fréquence mesurable en absence de synchronisation, c'est-à-dire lorsqu'aucun signal n'est reçu sur la borne 20.

Les informations ci-dessus permettent donc de déterminer plusieurs valeurs de $\alpha$ possibles. Dans la suite de la description, les valeurs de $\alpha$ sont uniquement celles pour lesquelles une synchronisation est possible. A titre d'illustration, $\alpha$ est égal à ½ ; ¾ ; ; 1 ; 3/2 ; 5/2 ; 2 ; 3 ; 4 ou 7/2 ou choisi dans le groupe composé de ½ ; ¾ ; 3/2 ; 5/2 ; 2 ; 3 ; 4 et 7/2. On notera aussi que la valeur $\alpha=1$ est toujours possible. Ainsi, si l'on souhaite uniquement que l'oscillateur 22 synchronisé oscille à la fréquence $f_t$, alors il n'est pas nécessaire de procéder à la détermination de différentes valeurs possibles pour $\alpha$.

Ici, les conditions de fonctionnement de l'oscillateur 22 sont réglées pour qu'il soit capable de se synchroniser automatiquement sur les fréquences $f_1$ et, en alternance, $f_2$ du signal $I_{RF(t)}$. Par synchronisation automatique, on désigne le fait que l'oscillateur 22 est capable de se synchroniser sur la fréquence $f_1$ puis ensuite sur la fréquence $f_2$ et vice versa sans qu'entre temps il soit nécessaire de modifier les conditions de fonctionnement de cet oscillateur. Les conditions de fonctionnement sont définies comme étant les valeurs de l'intensité du courant $I_d$ et du champ $H_b$. Autrement dit, l'oscillateur 22 doit être capable de se synchroniser sur la fréquence $f_1$ et, en alternance, sur la fréquence $f_2$ sans qu'il soit nécessaire de modifier à chaque fois le courant $I_d$ ou le champ $H_b$ lorsque l'on passe de la fréquence $f_1$ à la fréquence $f_2$ et inversement.

Dans ce mode de réalisation, on souhaite que lorsque l'oscillateur 22 est synchronisé sur les fréquences $f_1$ et $f_2$, il oscille aux fréquences, respectivement, $\alpha f_1$ et $\alpha f_2$, avec $\alpha$ strictement supérieur à un et, de préférence, supérieur ou égal à deux ou trois. De préférence, $\alpha$ est choisi dans le groupe composé de 3/2 ; 2 ; 5/2 et 3. $\alpha$ égal à deux fonctionne bien. Pour cela, le courant $I_d$ et le champ $H_b$ sont réglés pour que la fréquence libre $f_{lo}$ d'oscillation soit à la fois proche de $\alpha f_1$ et de $\alpha f_2$. A cet effet, ici, les intensités des courants $I_d$ et $I_{cm}$ sont réglées pour que la fréquence libre $f_{lo}$ soit égale à $\alpha f_p$. Le réglage se fait par exemple :

- en fixant l'intensité du courant $I_d$ juste au-dessus du seuil $I_c$, puis
- en déterminant à l'aide de la relation (2), le champ magnétique $H_b$ qui permet d'obtenir une fréquence libre d'oscillation égale à $\alpha f_p$, et enfin
- en déterminant l'intensité du courant $I_{cm}$ qui permet d'obtenir ce champ $H_b$ dans la couche libre 46.

La synchronisation ne se produit que si la fréquence $f_t$ appartient à une plage $[f_p - \delta_p ; f_p + \delta_p]$, Dans le cas présent, la largeur $2\delta_p$ de cette plage doit être suffisamment grande pour permettre à l'oscillateur 22 de se synchroniser sur la fréquence $f_1$ et, en alternance sur la fréquence $f_2$. La largeur de cette plage croît lorsque l'amplitude du signal électrique $I_{RF}(t)$ croît. Par conséquent, ici, l'amplificateur du bloc 12 est ajusté pour que les fréquences $f_1$ et $f_2$ appartiennent à la plage $[f_p - \delta_p ; f_p + \delta_p]$. Par exemple, l'amplitude du signal $I_{RF}(t)$ est amplifiée jusqu'à ce que cette amplitude corresponde à un champ magnétique $H_a$ dont l'intensité à l'intérieur de la couche libre 46 soit au moins supérieure à 1 Oe et, de préférence, supérieur à 10 Oe.

Le fonctionnement du démodulateur 2 va maintenant être décrit plus en détail en regard du procédé de la figure 4.

Le procédé de la figure 4 est décrit dans le cas particulier où la fréquence de modulation $f_m$ est égale à 2 MHz, la profondeur de modulation est égale à 200 MHz et la fréquence $f_p$ de la porteuse est égale à 10 GHz.

Initialement, lors d'une étape 100, l'intensité des courants $I_d$ et $I_{cm}$ sont réglées pour que la fréquence libre $f_{lo}$ soit égale à $\alpha f_p$. De plus, l'intensité du courant $I_d$ est choisie supérieure ou égale à l'intensité du courant critique $I_c$ de manière à ce que le dispositif magnétorésistif 40 oscille.

Lors d'une étape 102, le bloc 12 de mise en forme du signal $I_{RF}(t)$ est réglé pour que les fréquences $f_1$ et $f_2$ appartiennent à la plage $[f_p - \delta_p ; f_p + \delta_p]$.

Débute alors une phase 104 lors de laquelle l'oscillateur 22 reçoit sur la borne 10 le signal a démodulé et restitue sur la borne 30 le signal démodulé. Lors de cette phase 104, l'oscillateur se synchronise automatiquement et en alternance sur les fréquences $f_1$ et $f_2$ en fonction du bit d'information codé sur le signal $I_{RF}(t)$ reçu sur la borne 20 de synchronisation.

Plus précisément, lors d'une étape 106, lorsque le signal $I_{RF}(t)$ est à la fréquence $f_1$, l'oscillateur 22 se synchronise sur cette fréquence et oscille à la fréquence $\alpha f_1$. Cette fréquence d'oscillation $\alpha f_1$ correspond à une amplitude d'oscillation $p_1$ donnée. Par exemple, l'amplitude $p_1$ peut être approximée à l'aide de la relation suivante : $p_1 = \alpha |f_1 - f_p|/N$, où | ... | est l'opération valeur absolue.

Cette amplitude $p_1$ du signal s(t) correspond à une résistance $R_1$ du dispositif magnétorésistif 40.

Lors d'une étape 108, lorsque la fréquence du signal $I_{RF}(t)$ est égale à la fréquence $f_2$, l'oscillateur 22 se synchronise et oscille avec une fréquence $\alpha f_2$. De façon similaire à ce qui a été décrit pour la fréquence $\alpha f_1$, ceci correspond à une amplitude $p_2$ d'oscillation approximée par la relation suivante : $p_2 = \alpha |f_2 - f_p|/N$.

Cette amplitude $p_2$ correspondante à une résistance $R_2$ du dispositif magnétorésistif 40 différente de la résistance $R_1$.

Le signal s(t) produit sur l'électrode de sortie 24 est donc modulé en amplitude par les fréquences $f_1$ et $f_2$.

Lors d'une étape 110, le signale s(t) est filtré par le filtre passe-bas 28. Le filtre passe-bas 28 extrait uniquement les composantes basses fréquences du signal oscillant s(t). Ce signal oscillant filtré est alors transmis sur la borne 30 en tant que signal démodulé en fréquence.

Plus précisément, la différence de résistance entre les étapes 106 et 108 se traduit par une tension continue U sur la sortie 29 du filtre 28 qui est égale à $U_1$ lorsque l'oscillateur 22 est synchronisé sur la fréquence $f_1$ et à $U_2$ lorsque l'oscillateur 22 est synchronisé sur la fréquence $f_2$. L'écart $\delta U$ entre les valeurs $U_1$ et $U_2$ peut être approximé par la relation suivante : $\delta U = \delta R_{max} I_d |f_1 - f_2|/N$, où $\delta R_{max}$ est la variation maximale de la résistance de la jonction tunnel du dispositif 40.

Par exemple, pour une variation maximale $\delta R_{max}$ de 50 $\Omega$ et avec une intensité du courant $I_d$ de 1 mA, $\delta U$ est de l'ordre de quelques mV.

Ainsi, le démodulateur 2 génère un signal logique qui prend la valeur $U_1$ lorsque qu'un bit « 0 » est reçu et la valeur $U_2$ lorsqu'un bit « 1 » est reçu.

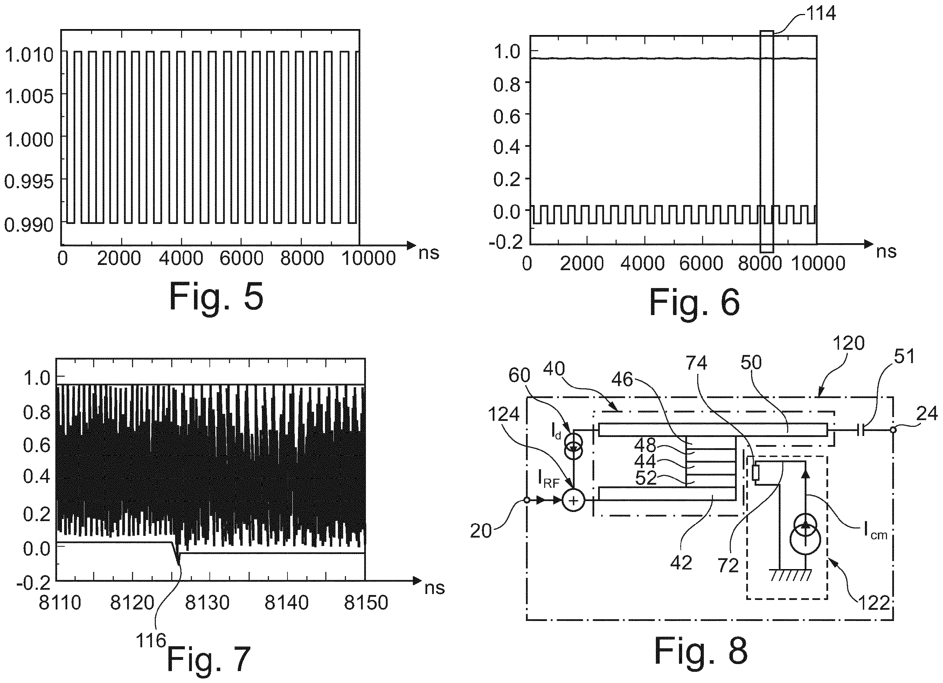

Les figures 5 à 7 représentent différents graphes obtenus par simulation du fonctionnement du démodulateur 2.

Le graphe de la figure 5 représente en fonction du temps les bits d'informations codés dans le signal $I_{RF}(t)$. Dans ce cas particulier, à chaque période $T_m$ le bit d'information à transmettre change de valeur.

Le graphe de la figure 6 représente en fonction du temps et à la même échelle l'évolution de l'enveloppe du signal s(t) produit par l'oscillateur 22 lorsque ce signal $I_{RF}(t)$ est reçu sur la borne 20. Sur la figure 6, les créneaux qui se dessinent en bas de l'enveloppe sont provoqués par les variations d'amplitude du signal s(t) selon qu'il est synchronisé sur la fréquence $f_1$ ou $f_2$.

Sur cette figure 6, un cadre 114 entoure une portion du signal s(t) qui a été grossie sur le graphe de la figure 7.

Le graphe de la figure 7 montre en agrandi la transition entre un état dans lequel l'oscillateur est synchronisé sur la fréquence $f_1$ vers un autre état dans lequel l'oscillateur est synchronisé sur la fréquence $f_2$. La courbe 116 en noir illustre le fait que la variation d'amplitude lors d'un changement de l'information codée dans le signa $I_{RF}(t)$ ne se fait pas instantanément. En effet, le passage de l'amplitude $p_1$ vers l'amplitude $p_2$ se fait en suivant une courbe dont l'enveloppe varie exponentiellement en $e^{-t\Gamma c}$, où t est le temps et $\Gamma_c$ est le taux de relaxation d'amplitude du dispositif magnétorésistif 40. $\Gamma_c$ est un taux de variation exprimé en Hertz. Le fait que la modification de l'amplitude ne se produise pas instantanément montre que la fréquence de modulation $f_m$ doit être strictement inférieure à cette fréquence $\Gamma_c$. Il a été mesuré expérimentalement, que la fréquence $\Gamma_c$ est comprise entre 50 MHz et 50 GHz et typiquement comprise entre 100 MHz et 10 GHz. Ainsi, le débit maximum d'informations est compris entre 50 Mbit/s et 10 ou 50 Gbit/s.

La figure 8 représente un oscillateur 120 susceptible d'être utilisé en lieu et place de l'oscillateur 22. Cet oscillateur 120 est identique à l'oscillateur 22 sauf que le générateur 70 est remplacé par un générateur 122 et le générateur 60 est raccordé à l'électrode d'entrée 42 par l'intermédiaire d'un sommateur 124.

Le générateur 122 est identique au générateur 70 sauf que le sommateur 80 est omis. Ainsi, dans ce mode de réalisation, la synchronisation avec le signal $I_{RF}(t)$ ne se fait pas par l'intermédiaire d'un champ magnétique alternatif. Dans ce mode de réalisation, le champ magnétique $H_b$ est constant.

Le sommateur 124 possède une entrée directement raccordée à la sortie du générateur 60 de courant continu et une autre entrée directement raccordée à la borne 20 de synchronisation. Une sortie de ce sommateur 124 est directement raccordée à l'électrode 42. Par conséquent, ce sommateur 124 ajoute le signal $I_{RF}(t)$ au courant continu $I_d$. Ainsi, lorsque l'oscillateur 120 est utilisé à la place de l'oscillateur 22, la synchronisation de la fréquence de l'oscillateur sur les fréquences $f_1$ et, en alternance, $f_2$ se fait en injectant le signal électrique $I_{RF}(t)$ sur l'électrode 42.

Le fonctionnement du démodulateur 2 lorsqu'il est équipé de l'oscillateur 120 se déduit des explications qui ont été précédemment données dans le cas de l'oscillateur 22. En particulier, pour que la synchronisation de l'oscillateur 120 sur les fréquences $f_1$ et $f_2$ se produise, il faut régler les intensités des courants $I_d$ et $I_{cm}$ comme décrit précédemment. Il faut également que l'amplitude du courant $I_{RF}(t)$ ne soit pas négligeable devant l'intensité du courant $I_d$. Pour cela, le bloc 12 est réglé pour que l'amplitude du courant $I_{RF}(t)$ soit au moins supérieure à 10% et, de préférence supérieure à 30% ou 50%, de l'intensité du courant $I_d$.

De nombreuses autres modes de réalisation sont possibles. Par exemple, les informations peuvent être codées dans le signal $I_{RF}(t)$ non pas à l'aide de seulement deux fréquences mais à l'aide de plus de deux fréquences. Une telle modulation à l'aide de plus de deux fréquences est également connue sous l'acronyme anglais de MFSK (Multiple Frequency Shift Keying). Dans ce cas, l'oscillateur doit être réglé pour pouvoir se synchroniser sur chacune des fréquences codant une information. En d'autres termes, ce qui a été décrit ici pour deux fréquences fonctionne aussi pour n fréquences avec n supérieur ou égal à deux.

Le générateur du champ magnétique $H_b$ peut être distinct de celui qui génère le champ $H_a$.

Il n'est pas nécessaire que la fréquence libre $f_{lo}$ soit strictement égale à $\alpha f_p$. En variante, les intensités des courants $I_{cm}$ et $I_d$ sont réglées de manière à ce que la fréquence $f_{lo}$ soit égale à la fréquence $\alpha f_p$ à plus ou moins 60 % près et de préférence à plus ou moins 45 ou 30 ou 10% près. Avantageusement, les intensités des courants $I_d$ et $I_{cm}$ sont réglées de telle façon que la fréquence libre $f_{lo}$ appartiennent à la plage $[\alpha f_1 ; \alpha f_2]$ où les fréquences $f_1$ et $f_2$ sont respectivement la plus petite et la plus grande fréquences utilisées dans la modulation de fréquence pour coder des informations respectives.

De nombreux autres modes de réalisation du dispositif magnétorésistif 40 sont possibles. Par exemple, la direction de plus facile aimantation de la couche libre et/ou de la couche de référence n'est pas forcément contenue dans le plan de la couche. Par exemple, la direction de plus facile aimantation peut être perpendiculaire au plan de la couche.

Il est possible également que la couche 44 soit un multicouche par exemple un SyF (Synthetic Ferrimagnetic) voire un SAF (Synthetic AntiFerromagnetic). Cela permet de piéger la direction d'aimantation de la cette couche sans qu'il soit nécessaire d'utiliser une couche antiferromagnétique complémentaire pour cela. La couche 52 peut donc être omise dans ce cas.

L'espaceur 48 peut être réalisé dans un matériau électriquement conducteur tel que le cuivre (Cu). Les propriétés magnétorésistives du pilier sont alors qualifiées de magnétorésistance géante ou GMR (Giant Magneto Resistance).

Un (ou plusieurs) polariseur peut aussi être utilisé pour réaliser le dispositif magnétorésistif en plus de la couche de référence. Un polariseur est une couche ou un multicouche magnétique dont l'aimantation est en dehors du plan de la couche et, par exemple, perpendiculaire au plan de la couche. Le polariseur permet de polariser en spin le courant qui le traverse. Typiquement, le polariseur est composé de plusieurs sous-couches superposées les unes sur les autres, par exemple une alternance de couches magnétiques et métalliques (par exemple $(Co/Pt)_n$). Ici, le polariseur n'est pas décrit plus en détail. Pour plus d'informations sur les polariseurs, il est possible de se référer à la demande de brevet FR2 817 998. La présence du polariseur permet d'obtenir une précession de l'aimantation de la couche libre en dehors de son plan. Cela permet par exemple de faire fonctionner l'oscillateur en champ nul, c'est-à-dire en absence de champ magnétique extérieur statique. Par exemple, un polariseur est directement déposé sur l'électrode 42. Ainsi, dans le mode de réalisation de la figure 8, le générateur 122 de champ magnétique peut être omis, par exemple, si un polariseur est utilisé.

Le générateur 70 de champ magnétique peut être réalisé différemment. Par exemple, le champ magnétique $H_b$ peut être généré par une couche aimantée située à proximité de la couche libre.

Le champ magnétique $H_b$ peut être parallèle ou perpendiculaire à la direction de plus facile aimantation de la couche libre. Il peut aussi former un angle quelconque avec cette direction de plus facile aimantation. Le choix de cet angle modifie les valeurs du coefficient $\alpha$ possibles.

Les modes de réalisation des figures 3 et 8 peuvent être combinés. Ainsi, le signal $I_{RF}(t)$ peut être injecté à la fois sur les sommateurs 80 et 124.

## Revendications

1.  Démodulateur d'un signal électrique modulé en fréquence autour d'une fréquence porteuse $f_p$ avec une fréquence de modulation $f_m$, ce démodulateur comportant :

    - une borne (10) d'acquisition sur laquelle est reçu le signal modulé en fréquence, et
    - une borne (30) de restitution sur laquelle est restitué le signal électrique démodulé en fréquence,

    **caractérisé en ce que** le démodulateur comporte :

    - un oscillateur radiofréquence (22 ; 120) comportant :

        • un dispositif magnétorésistif (40) au sein duquel circule un courant électrique polarisé en spin pour produire un signal oscillant sur une électrode de sortie (24), ce dispositif étant formé d'un empilement de couches magnétiques et non magnétiques dont l'amplitude des variations de sa résistance varie en fonction de la fréquence du signal oscillant produit,
        • une source (60) de courant pour faire circuler un courant continu d'électrons dans lesdites couches perpendiculairement à celles-ci ou un générateur (70 ; 122) de champ magnétique apte à générer un champ magnétique continu dont les lignes de champ traversent la couche libre du dispositif magnétorésistif avec une intensité supérieure ou égale à 1 Oe, la source de courant et/ou le générateur de champ magnétique continu étant réglés de manière à ce que, dans des conditions de fonctionnement identiques, l'oscillateur radiofréquence se synchronise automatiquement sur des oscillations à une fréquence $f_1$ et, en alternance, sur des oscillations à une fréquence $f_2$, où les fréquences $f_1$ et $f_2$ sont des fréquences utilisées dans le signal modulé en fréquence pour coder des informations respectives, tel que, lorsque l'oscillateur radiofréquence est synchronisé, la fréquence d'un signal oscillant produit sur une électrode (50) de sortie devient égale à $\alpha f_t$, où :

            - $f_t$ est la fréquence d'un signal reçu sur une borne (20) de synchronisation, et
            - $\alpha$ est un nombre rationnel s'écrivant sous la forme d'une fraction M/P, où M et P sont des entiers positifs non nuls, et

        • la borne (20) de synchronisation de la fréquence du signal oscillant sur la fréquence du signal reçu sur cette borne, cette borne étant raccordée à la borne d'acquisition,
        • un sommateur (124) équipé de la borne de synchronisation, ce sommateur étant apte à additionner le signal électrique reçu sur la borne de synchronisation au courant continu qui traverse lesdites couches perpendiculairement à celles-ci de manière à ce que la fréquence du signal oscillant se synchronise sur la fréquence du signal reçu sur la borne de synchronisation, et/ou un générateur (70) de champ magnétique équipé de la borne de synchronisation, ce générateur étant apte à générer un champ magnétique alternatif dont la fréquence est fonction de la fréquence du signal reçu sur la borne de synchronisation et dont les lignes de champ traversent la couche libre de manière à ce que la fréquence du signal oscillant se synchronise sur la fréquence du signal reçu sur la borne de synchronisation, et

    - un filtre passe-bas (28) raccordé :

• à l'électrode (24) de sortie du dispositif magnétorésistif pour filtrer le signal oscillant, et

• à la borne (30) de restitution pour fournir en tant que signal électrique démodulé un signal filtré, la fréquence de coupure $f_c$ à -3 dB de ce filtre étant strictement inférieure à la fréquence $f_p$ et supérieure à la fréquence $f_m$.

2. Démodulateur selon la revendication 1, dans lequel l'empilement de couches du dispositif magnétorésistif comprend au moins les couches suivantes :

- une électrode d'entrée (42) par laquelle est injecté un courant électrique continu,
- une première couche magnétique (44), dite « couche de référence », apte à polariser en spin le courant électrique et dont l'aimantation est de direction fixe,
- une seconde couche magnétique (46), dite « couche libre », dont l'aimantation peut osciller lorsqu'elle est traversée par le courant polarisé en spin,
- une couche non magnétique (48), dite « espaceur », interposée entre les deux couches précédentes pour former une jonction tunnel ou une vanne de spin, et
- l'électrode (50) de sortie sur laquelle est produit le signal oscillant à une fréquence d'oscillation fonction de l'intensité du courant continu ou de l'amplitude d'un champ magnétique continu dont les lignes de champ traversent la couche libre,
- la section transversale d'au moins l'une des couches de cet empilement présentant un diamètre inférieur à 300 nm.

3. Démodulateur selon l'une quelconque des revendications précédentes, dans lequel l'oscillateur radiofréquence est configuré pour produire un signal oscillant aux fréquences $\alpha f_1$ et $\alpha f_2$ lorsque l'oscillateur radiofréquence est synchronisé sur les oscillations de fréquences, respectivement, $f_1$ et $f_2$, où $\alpha$ a une valeur strictement supérieure à un.

4. Procédé de démodulation d'un signal électrique modulé en fréquence autour d'une fréquence porteuse $f_p$ avec une fréquence de modulation $f_m$ à l'aide d'un démodulateur conforme à l'une quelconque des revendications précédentes, ce procédé comportant :

- la réception sur la borne d'acquisition du signal électrique modulé, et
- la restitution sur la borne de restitution du signal électrique démodulé,

**caractérisé en ce que** le procédé comporte :

- la synchronisation (106, 108) de l'oscillateur radiofréquence du démodulateur, dans des conditions de fonctionnement identiques, sur des oscillations de fréquence $f_1$ et, en alternance, sur des oscillations de fréquence $f_2$, où les fréquences $f_1$ et $f_2$ sont des fréquences utilisées dans le signal modulé en fréquence pour coder des informations respectives, :

• en réglant la source de courant et/ou le générateur de champ magnétique continu de manière à ce que, dans des conditions de fonctionnement identiques, l'oscillateur radiofréquence se synchronise automatiquement sur des oscillations à la fréquence $f_1$ et, en alternance, sur des oscillations à la fréquence $f_2$, tel que, lorsque l'oscillateur radiofréquence est synchronisé, la fréquence du signal oscillant produit sur l'électrode (50) de sortie devient égale à $\alpha f_t$, où :

- $f_t$ est la fréquence du signal reçu sur la borne (20) de synchronisation, et
- $\alpha$ est un nombre rationnel s'écrivant sous la forme d'une fraction M/P, où M et P sont des entiers positifs non nuls, et

• en raccordant la borne de synchronisation à la borne d'acquisition,

- un filtrage (110), à l'aide du filtre passe-bas du démodulateur, du signal oscillant généré sur l'électrode de sortie et la fourniture du signal filtré sur la borne de restitution en tant que signal électrique démodulé.

5. Procédé selon la revendication 4, dans lequel le courant continu et/ou le champ magnétique continu sont réglés (100) de manière à ce que la fréquence libre $f_{lo}$ d'oscillation du signal oscillant produit en absence de signal sur la borne de synchronisation soit comprise entre des fréquences $\alpha f_1$ et $\alpha f_2$, où les fréquences $f_1$ et $f_2$ sont, respectivement, la plus petite et la plus grande des fréquences utilisées dans le signal modulé en fréquence pour coder une information et $\alpha$ est un nombre rationnel.

**6.** Procédé selon la revendication 5, dans lequel le signal électrique modulé en fréquence est amplifié (102) de manière à ce que l'étendue de la plage, autour de la fréquence $f_p$, des fréquences avec lesquels l'oscillateur radiofréquence peut se synchroniser soit strictement supérieur à $|f_1 - f_2|$, où $|...|$ est la valeur absolue.

**7.** Procédé selon la revendication 6, dans lequel le signal électrique modulé en fréquence est amplifié de manière à ce que son amplitude sur la borne de synchronisation soit supérieure à 10 % de l'intensité du courant continu ou corresponde à un champ magnétique alternatif dont l'intensité est supérieure à 1 Oe à l'intérieur de la couche libre lorsqu'il est transformé en champ magnétique par le générateur.

**8.** Procédé selon l'une quelconque des revendications 4 à 7, dans lequel la fréquence de modulation $f_m$ est strictement inférieure à une fréquence $\Gamma_c$, où $\Gamma_c$ est le taux de relaxation d'amplitude du dispositif magnétorésistif.

**Patentansprüche**

**1.** Demodulator eines elektrischen Signals, das um eine Trägerfrequenz $f_p$ herum mit einer Modulationsfrequenz $f_m$ moduliert ist, wobei dieser Demodulator aufweist:

- eine Erfassungsklemme (10), an der das frequenzmodulierte Signal empfangen wird, und
- eine Wiedergabeklemme (30), an der das frequenzdemodulierte elektrische Signal wiedergegeben wird,

**dadurch gekennzeichnet, dass** der Demodulator aufweist:

- einen Funkfrequenzoszillator (22 ; 120), der aufweist:

• eine Magnetwiderstandsvorrichtung (40), innerhalb der ein spinpolarisierter elektrischer Strom fließt, um ein oszillierendes Signal an einer Ausgangselektrode (24) zu erzeugen, wobei diese Vorrichtung von einer Stapelung magnetischer und nicht magnetischer Schichten gebildet wird, deren Amplitude der Schwankungen ihres Widerstands abhängig von der Frequenz des erzeugten oszillierenden Signals variiert,
• eine Stromquelle (60), um einen Elektronen-Gleichstrom in den Schichten lotrecht zu diesen fließen zu lassen, oder ein Magnetfeldgenerator (70 ; 122), der ein Gleichstrom-Magnetfeld erzeugen kann, dessen Feldlinien die freie Schicht der Magnetwiderstandsvorrichtung mit einer Stärke von mehr als oder gleich 1 Oe durchqueren, wobei die Stromquelle und/oder der Gleichstrom-Magnetfeldgenerator so geregelt sind, dass bei gleichen Betriebsbedingungen der Funkfrequenzoszillator sich automatisch mit Oszillationen einer Frequenz $f_1$ und alternierend mit Oszillationen einer Frequenz $f_2$ synchronisiert, wobei die Frequenzen $f_1$ und $f_2$ im frequenzmodulierten Signal verwendete Frequenzen sind, um jeweilige Informationen zu codieren, derart, dass, wenn der Funkfrequenzoszillator synchronisiert ist, die Frequenz eines an einer Ausgangselektrode (50) erzeugten oszillierenden Signals gleich $\alpha f_t$ wird, wobei

- $f_t$ die Frequenz eines an einer Synchronisationsklemme (20) empfangenen Signals ist, und
- $\alpha$ eine rationale Zahl ist, die in Form eines Bruchs M/P geschrieben wird, wobei M und P positive ganze Zahlen ungleich Null sind, und

• die Klemme (20) zur Synchronisation der Frequenz des oszillierenden Signals mit der Frequenz des an dieser Klemme empfangenen Signals, wobei diese Klemme an die Erfassungsklemme angeschlossen ist,
• ein Summierglied (124), das mit der Synchronisationsklemme ausgestattet ist, wobei dieses Summierglied das an der Synchronisationsklemme empfangene elektrische Signal zum Gleichstrom addieren kann, der die Schichten lotrecht zu diesen durchquert, so dass die Frequenz des oszillierenden Signals sich mit der Frequenz des an der Synchronisationsklemme empfangenen Signals synchronisiert, und/oder einen Magnetfeldgenerator (70), der mit der Synchronisationsklemme ausgestattet ist, wobei dieser Generator ein Wechselstrom-Magnetfeld erzeugen kann, dessen Frequenz von der Frequenz des an der Synchronisationsklemme empfangenen Signals abhängt, und dessen Feldlinien die freie Schicht durchqueren, so dass die Frequenz des oszillierenden Signals sich mit der Frequenz des an der Synchronisationsklemme empfangenen Signals synchronisiert, und

- ein Tiefpassfilter (28), angeschlossen:

• an die Ausgangselektrode (24) der Magnetwiderstandsvorrichtung, um das oszillierende Signal zu filtern, und

• an die Wiedergabeklemme (30), um als demoduliertes elektrisches Signal ein gefiltertes Signal zu liefern, wobei die Grenzfrequenz $f_c$ bei -3 dB dieses Filters strikt niedriger als die Frequenz $f_p$ und höher als die Frequenz $f_m$ ist.

2. Demodulator nach Anspruch 1, wobei die Stapelung von Schichten der Magnetwiderstandsvorrichtung mindestens die folgenden Schichten enthält:

- eine Eingangselektrode (42), durch die ein elektrischer Gleichstrom eingespeist wird,
- eine erste magnetische Schicht (44), "Bezugsschicht" genannt, die den elektrischen Strom spinpolarisieren kann und deren Magnetisierung eine festgelegte Richtung hat,
- eine zweite magnetische Schicht (46), "freie Schicht" genannt, deren Magnetisierung oszillieren kann, wenn sie vom spinpolarisierten Strom durchquert wird,
- eine nicht magnetische Schicht (48), "Abstandshalter" genannt, die zwischen die zwei vorhergehenden Schichten eingefügt wird, um eine Tunnelverbindung oder ein Spinventil zu bilden, und
- die Ausgangselektrode (50), an der das oszillierende Signal mit einer Oszillationsfrequenz abhängig von der Stärke des Gleichstroms oder der Amplitude eines Gleichstrom-Magnetfelds erzeugt wird, dessen Feldlinien die freie Schicht durchqueren,
- wobei der Querschnitt mindestens einer der Schichten dieser Stapelung einen Durchmesser von weniger als 300 nm aufweist.

3. Demodulator nach einem der vorhergehenden Ansprüche, wobei der Funkfrequenzoszillator konfiguriert ist, ein oszillierendes Signal mit den Frequenzen $\alpha f_1$ und $\alpha f_2$ zu erzeugen, wenn der Funkfrequenzoszillator mit den Oszillationen von Frequenzen $f_l$ bzw. $f_2$ synchronisiert ist, wobei $\alpha$ einen Wert strikt größer als Eins hat.

4. Verfahren zur Demodulation eines um eine Trägerfrequenz $f_p$ herum mit einer Modulationsfrequenz $f_m$ frequenzmodulierten elektrischen Signals mit Hilfe eines Demodulators nach einem der vorhergehenden Ansprüche, wobei dieses Verfahren aufweist:

- den Empfang des modulierten elektrischen Signals an der Erfassungsklemme, und
- die Wiedergabe des demodulierten elektrischen Signals an der Wiedergabeklemme,

dadurch gekennzeichnet, dass das Verfahren aufweist:

- die Synchronisation (106, 108) des Funkfrequenzoszillators des Demodulators, unter gleichen Betriebsbedingungen, mit Frequenzoszillationen $f_1$ und, alternierend, mit Frequenzoszillationen $f_2$, wobei die Frequenzen $f_1$ und $f_2$ im frequenzmodulierten Signal verwendete Frequenzen sind, um jeweilige Informationen zu codieren:

• indem die Stromquelle und/oder der Gleichstrom-Magnetfeldgenerator so geregelt werden, dass unter gleichen Betriebsbedingungen der Funkfrequenzoszillator sich automatisch mit Oszillationen der Frequenz $f_1$ und alternierend mit Oszillationen der Frequenz $f_2$ synchronisiert, derart, dass, wenn der Funkfrequenzoszillator synchronisiert ist, die Frequenz des an der Ausgangselektrode (50) erzeugten oszillierenden Signals gleich $\alpha f_t$ wird, wobei

- $f_t$ die Frequenz des an der Synchronisationsklemme (20) empfangenen Signals ist, und
- $\alpha$ eine rationale Zahl ist, die in Form eines Bruchs M/P geschrieben wird, wobei M und P positive ganze Zahlen ungleich Null sind, und

• indem die Synchronisationsklemme an die Erfassungsklemme angeschlossen wird,

- eine Filterung (110), mit Hilfe des Tiefpassfilters des Demodulators, des an der Ausgangselektrode erzeugten oszillierenden Signals und die Lieferung des gefilterten Signals an der Wiedergabeklemme als demoduliertes elektrisches Signal.

5. Verfahren nach Anspruch 4, wobei der Gleichstrom und/oder das Gleichstrom-Magnetfeld so geregelt werden (100), das die freie Oszillationsfrequenz $f_{lo}$ des oszillierenden Signals, die in Abwesenheit eines Signals an der Synchronisationsklemme erzeugt wird, zwischen Frequenzen $\alpha f_1$ und $\alpha f_2$ liegt, wobei die Frequenzen $f_1$ und $f_2$ die kleinste bzw. die größte der im frequenzmodulierten Signal verwendeten Frequenzen sind, um eine Information zu codieren,

und $\alpha$ eine rationale Zahl ist.

**6.** Verfahren nach Anspruch 5, wobei das frequenzmodulierte elektrische Signal verstärkt wird (102), damit die Größe des Bereichs um die Frequenz $f_p$ herum der Frequenzen, mit denen der Funkfrequenzoszillator sich synchronisieren kann, strikt größer als $|fi-f_2|$ ist, wobei $|...|$ der Absolutwert ist.

**7.** Verfahren nach Anspruch 6, wobei das frequenzmodulierte elektrische Signal so verstärkt wird, dass seine Amplitude an der Synchronisationsklemme größer als 10 % der Stärke des Gleichstroms ist oder einem Wechselstrom-Magnetfeld entspricht, dessen Stärke größer als 1 Oe im Inneren der freien Schicht ist, wenn es vom Generator in ein Magnetfeld umgewandelt wird.

**8.** Verfahren nach einem der Ansprüche 4 bis 7, wobei die Modulationsfrequenz $f_m$ strikt niedriger als eine Frequenz $\Gamma_c$ ist, wobei $\Gamma_c$ der Amplitudenrelaxationsgrad der Magnetwiderstandsvorrichtung ist.

**Claims**

**1.** Demodulator of an electrical signal frequency-modulated around a carrier frequency $f_p$ with a modulation frequency $f_m$, this demodulator comprising:

- an acquisition terminal (10) on which the frequency-modulated signal is received, and
- a retrieval terminal (30) on which the frequency-demodulated electrical signal is retrieved,

**characterized in that** the demodulator comprises:

- a radiofrequency oscillator (22; 120) comprising:

• a magnetoresistive device (40) within which there flows a spin-polarized electric current so as to produce an oscillating signal on an output electrode (24), this device being formed of a stack of magnetic and non-magnetic layers, the amplitude of the variations of whose resistance varies as a function of the frequency of the oscillating signal produced,
• a current source (60) to bring about the flow of a direct current of electrons in the said layers perpendicularly to them or a magnetic field generator (70; 122) able to generate a direct magnetic field whose field lines pass through the free layer of the magnetoresistive device with an intensity greater than or equal to 1 Oe, the current source and/or the direct magnetic field generator being adjusted in such a way that, under identical operating conditions, the radiofrequency oscillator synchronizes automatically to oscillations at a frequency $f_1$ and, alternately, to oscillations at a frequency $f_2$, where the frequencies $f_1$ and $f_2$ are frequencies used in the frequency-modulated signal to code respective items of information, such that, when the radiofrequency oscillator is synchronized, the frequency of an oscillating signal produced on an output electrode (50) becomes equal to $\alpha f_t$, where:

- $f_t$ is the frequency of a signal received on a synchronizing terminal (20), and
- $\alpha$ is a rational number which may be written in the form of a fraction M/P, where M and P are non-zero positive integers, and

• the terminal (20) for synchronizing the frequency of the oscillating signal to the frequency of the signal received on this terminal, this terminal being hooked up to the acquisition terminal,
• a summator (124) equipped with the synchronizing terminal, this summator being able to add the electrical signal received on the synchronizing terminal to the direct current which passes through the said layers perpendicularly to them in such a way that the frequency of the oscillating signal synchronizes to the frequency of the signal received on the synchronizing terminal, and/or a magnetic field generator (70) equipped with the synchronizing terminal, this generator being able to generate an alternating magnetic field whose frequency is dependent on the frequency of the signal received on the synchronizing terminal and whose field lines pass through the free layer in such a way that the frequency of the oscillating signal synchronizes to the frequency of the signal received on the synchronizing terminal, and

- a low-pass filter (28) hooked up:

• to the output electrode (24) of the magnetoresistive device so as to filter the oscillating signal, and
• to the retrieval terminal (30) so as to provide in the guise of demodulated electrical signal a filtered signal, the -3 dB cutoff frequency $f_c$ of this filter being strictly less than the frequency $f_p$ and greater than the frequency $f_m$.

2. Demodulator according to Claim 1, in which the stack of layers of the magnetoresistive device comprises at least the following layers:

- an input electrode (42) through which is injected a direct electric current,
- a first magnetic layer (44), termed "reference layer", able to spin-polarize the electric current and whose magnetization is of fixed direction,
- a second magnetic layer (46), termed "free layer", whose magnetization can oscillate when the spin-polarized current passes through it,
- a non-magnetic layer (48), termed "spacer", interposed between the previous two layers to form a tunnel junction or a spin valve, and
- the output electrode (50) on which is produced the signal oscillating at an oscillation frequency dependent on the intensity of the direct current or on the amplitude of a direct magnetic field whose field lines pass through the free layer,
- the cross section of at least one of the layers of this stack exhibiting a diameter of less than 300 nm.

3. Demodulator according to any one of the preceding claims, in which the radiofrequency oscillator is configured to produce a signal oscillating at the frequencies $\alpha f_1$ and $\alpha f_2$ when the radiofrequency oscillator is synchronized to the oscillations of frequencies, respectively, $f_1$ and $f_2$, where $\alpha$ has a value strictly greater than one.

4. Method of demodulating an electrical signal frequency-modulated around a carrier frequency $f_p$ with a modulation frequency $f_m$ with the aid of a demodulator in accordance with any one of the preceding claims, this method comprising:

- the reception on the acquisition terminal of the modulated electrical signal, and
- the retrieval on the retrieval terminal of the demodulated electrical signal, **characterized in that** the method comprises:
- the synchronization (106, 108) of the radiofrequency oscillator of the demodulator, under identical operating conditions, to oscillations of frequency $f_1$ and, alternately, to oscillations of frequency $f_2$, where the frequencies $f_1$ and $f_2$ are frequencies used in the frequency-modulated signal to code respective items of information:

• by adjusting the current source and/or the direct magnetic field generator in such a way that, under identical operating conditions, the radiofrequency oscillator synchronizes automatically to oscillations at the frequency $f_1$ and, alternately, to oscillations at the frequency $f_2$, such that, when the radiofrequency oscillator is synchronized, the frequency of the oscillating signal produced on the output electrode (50) becomes equal to $\alpha f_t$, where:

- $f_t$ is the frequency of the signal received on the synchronizing terminal (20), and
- $\alpha$ is a rational number which may be written in the form of a fraction M/P, where M and P are non-zero positive integers, and

• by hooking up the synchronizing terminal to the acquisition terminal,

- a filtering (110), with the aid of the low-pass filter of the demodulator, of the oscillating signal generated on the output electrode and the provision of the filtered signal on the retrieval terminal in the guise of demodulated electrical signal.

5. Method according to Claim 4, in which the direct current and/or the direct magnetic field are adjusted (100) in such a way that the free frequency $f_{lo}$ of oscillation of the oscillating signal produced in the absence of any signal on the synchronizing terminal lies between frequencies $\alpha f_1$ and $\alpha f_2$, where the frequencies $f_1$ and $f_2$ are, respectively, the smallest and the largest of the frequencies used in the frequency-modulated signal to code an item of information and $\alpha$ is a rational number.

6. Method according to Claim 5, in which the frequency-modulated electrical signal is amplified (102) in such a way that the extent of the span, around the frequency $f_p$, of the frequencies with which the radiofrequency oscillator can synchronize is strictly greater than $|f_1 - f_2|$, where $|...|$ is the absolute value.

7.  Method according to Claim 6, in which the frequency-modulated electrical signal is amplified in such a way that its amplitude on the synchronizing terminal is greater than 10 % of the intensity of the direct current or corresponds to an alternating magnetic field whose intensity is greater than 1 Oe inside the free layer when it is transformed into a magnetic field by the generator.

8.  Method according to any one of Claims 4 to 7, in which the modulation frequency $f_m$ is strictly less than a frequency $\Gamma_c$, where $\Gamma_c$ is the amplitude relaxation rate of the magnetoresistive device.

Fig. 1

Fig. 2

Fig. 3

Fig. 4

EP 2 515 433 B1

Fig. 5

Fig. 6

Fig. 7

116

Fig. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011051481 A1
- US 2010296203 A1
- US 2010097730 A1
- US 5695864 A

- EP 1860769 A
- FR 2892871
- FR 0957888
- FR 2817998

**Littérature non-brevet citée dans la description**

- Self-homodyne rf demodulator using ferromagnetic nanowire. **YAMAGUCHI et al.** Applied Physics Letters. AIP, American Institute of Physics, 22 Mai 2007, vol. 90, 212505-212505
- **BAIBICH, M. ; BROTO, J.M. ; FERT, A. ; NGUYEN VAN DAU, F. ; PETROFF, F. ; ETIENNE, P. ; CREUZET, G. ; FRIEDERCH, A. ; CHAZELAS, J.** Giant magnetoresistance of (001)Fel(001)Cr magnetic superlattices. *Phys.Rev.Lett.,* 1988, vol. 61, 2472
- **MOODERA, JS. ; KINDER, LR. ; WONG, TM ; MESERVEY,R.** Large magnetoresistance at room temperature in ferromagnetic thin film tunnel junctions. *Phys.Rev.Lett,* 1995, vol. 74, 3273-6

- **KATINE, J.A. ; ALBERT, F.J. ; BUHRMAN, R.A. ; MYERS, E.B. ; RALPH, D.C.** Current-Driven Magnetization Reversal and Spin-Wave Excitations in Co /Cu /Co Pillars. *Phys.Rev.Lett.,* 2000, vol. 84, 3149
- **KISELEV, S.I. ; SANKEY, J.C. ; KRIVOROTOV, LN. ; EMLEY, N.C. ; SCHOELKOPF, R.J. ; BUHRMAN, R.A. ; RALPH, D.C.** Microwave oscillations of a nanomagnet driven by a spin-polarized current. *Nature,* 2003, vol. 425, 380
- **SERGEI URAZHDIN ; PHILLIP TABOR.** Franctional synchronization of spin-torque nano-oscillators. *Physical review letters, PRL,* 03 Septembre 2010, vol. 105, 104101
- **A. SLAVIN ; V. TIBERKEVICH.** Nonlinear auto-oscillator theory of microwave generation by spin-polarized current. *IEEE Transaction on magnetics,* 2009, vol. 45, 1875-1918